# DEMANDE DE BREVET EUROPEEN

(11) **EP 1 832 353 A2**
(43) Date de publication de la demande: **12.09.2007**
(21) Numéro de dépôt: 07103722.0
(22) Date de dépôt: 07.03.2007
(51) Int. Cl.: B08B 7/00, G03F 1/00

(54) **Nettoyage de masques de photolithographie**

(30) Priorité: 08.03.2006 FR 0650805
(71) Demandeur: ST MICROELECTRONICS S.A., 92120 Montrouge (FR)
(72) Inventeur: Martin, Christophe, 13090 Aix en Provence (FR)
(74) Mandataire: de Beaumont, Michel

(57) **Abrégé**

L'invention concerne un procédé et un équipement de nettoyage de masques (10) utilisés pour des étapes de photolithographie, comportant au moins une étape (23, 24) de traitement thermique sous pompage à une pression inférieure à la pression atmosphérique et à une température supérieure à la température ambiante.

## Description

### Domaine de l'invention

La présente invention concerne de façon générale l'industrie électronique et, plus particulièrement le nettoyage de masques utilisés pour la réalisation de motifs sur un substrat.

Un exemple d'application de la présente invention concerne les installations de fabrication de circuits électroniques sur des plaquettes, par exemple en matériau semiconducteur.

Un autre exemple d'application de la présente invention concerne les installations de réalisation de dispositifs optiques utilisant des masques pour des étapes de photolithographie.

### Exposé de l'art antérieur

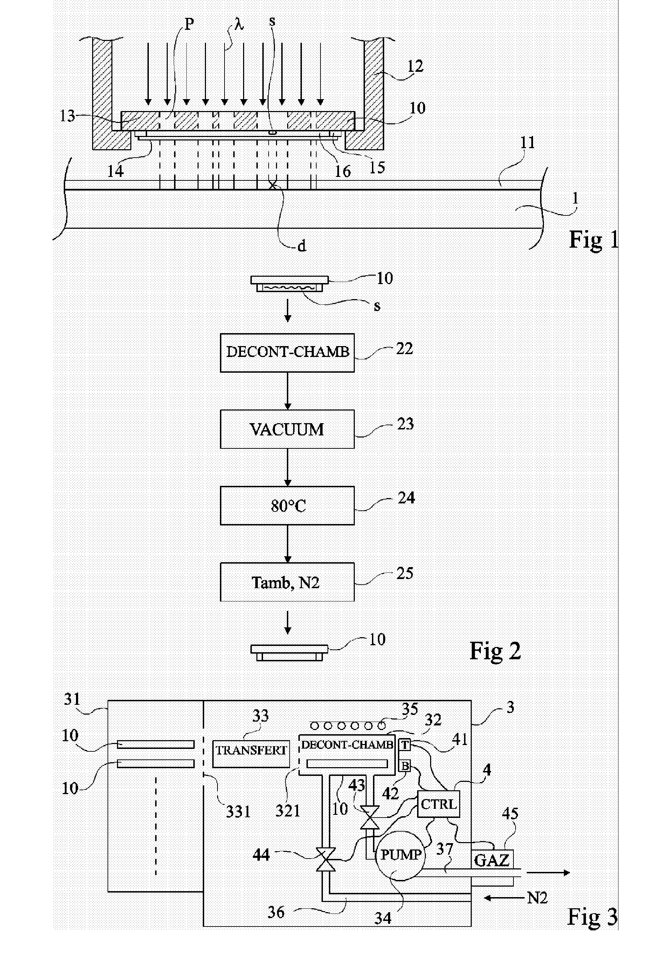

La figure 1 représente partiellement, de façon très schématique et sans respect d'échelle, un exemple classique d'équipement d'exposition d'une tranche 1 formant un substrat de fabrication de circuits intégrés, à travers un masque 10 pour la réalisation de motifs.

Les procédés de développement de motifs au moyen de masques se décomposent généralement en plusieurs étapes.

Une première étape consiste à déposer une couche de résine photosensible (positive ou négative) 11 sur la tranche semiconductrice 1.

Puis, l'ensemble est exposé à un rayonnement λ à travers un masque 10 afin d'insoler la résine selon des motifs p définis par le masque 10. En pratique, un même masque 10 est déplacé par un équipement 12 représenté partiellement en figure 1 à l'aplomb de la tranche 1 pour reproduire plusieurs fois les mêmes motifs (typiquement pour fabriquer plusieurs circuits identiques) .

Après exposition, la résine 11 est développée de façon à ne laisser subsister sur la tranche que les parties exposées ou non exposées selon le caractère positif ou négatif de la résine.

Le masque de résine ainsi formé sur la tranche 1 sert à des étapes ultérieures de gravure, d'implantation, etc. avant, le plus souvent, un retrait complet de la résine subsistante.

La succession d'étapes ci-dessus est reproduite plusieurs fois sur une même plaquette 1 avec différents masques de définition des circuits à réaliser.

Un masque 10 de photolithographie utilisé dans l'industrie électronique comporte une partie active 13 définissant des zones opaques et transparentes à un rayonnement λ. La partie active 13 est d'un côté du masque opposé à une face soumise au rayonnement. La partie active, en regard de la plaquette 1 est protégée par une pellicule 14. En pratique, la pellicule 14 est soit un film adhésif rapporté sur la surface du masque, soit un film tendu sur un cadre 15 formant entretoise avec la surface du masque, le cadre 15 comportant alors un filtre (non représenté) d'équilibrage des pressions entre l'extérieur et un intervalle 16 défini entre la partie active 13 et la pellicule 14. La pellicule 14 sert à éviter que des particules se déposent directement sur le masque, côté partie active, et l'intervalle 16 sert à écarter, de la partie active 13, la pellicule 14 sur laquelle se déposent des particules. Toute particule même de faible dimension (typiquement, entre une cinquantaine et quelques centaines de µm) susceptible de se trouver dans l'installation peut, si elle est très proche de la partie active 13 (donc dans l'intervalle 16), générer un défaut sur les circuits. Par contre, de telles particules ne sont pas gênantes si elles sont suffisamment loin de la partie active. Le filtre d'équilibrage de pression évite que de telles particules entrent dans l'intervalle 16.

Les masques de photolithographie constituent l'un des éléments les plus sensibles de la chaîne de fabrication de circuits électroniques dans la mesure où le moindre défaut sur un masque engendre un défaut sur tous les circuits fabriqués.

Bien que toutes les étapes s'effectuent sous atmosphère contrôlée dans des "salles blanches", des composés gazeux restent présents, même en faible concentration dans les différents équipements, y compris dans les équipements de photolithographie. Or, le filtre à particules n'est pas suffisant pour empêcher les molécules gazeuses de pénétrer dans l'intervalle 16. Une fois dans l'intervalle, l'étape d'exposition au rayonnement lumineux facilite la croissance sur la partie active 13 du masque (dans l'intervalle 16), de sels (s, figure 1) provenant des composés gazeux présents dans l'installation. De tels sels engendrent des défauts d dans le motif reproduit sur la résine 11, donc des défauts potentiels dans les circuits.

Dans l'exemple de fabrication des circuits semiconducteurs, les sels qui se déposent le plus souvent sont à base d'ammoniaque (NH₄)ᵢX_{y}, où X désigne un anion du type SO₄⁻, F , Cl⁻, CH₃COO, etc.

Bien que les masques soient stockés dans des boîtes hermétiques, et même ces boîtes sont purgées régulièrement pour accroître la durée de vie des masques, des sels finissent par s'accumuler à la surface des masques.

Il est donc impératif de nettoyer régulièrement les masques de photolithographie afin d'éliminer les sels se formant à leur surface. La durée d'utilisation d'un masque entre deux nettoyages est liée aux durées d'exposition et à l'énergie de la source lumineuse.

Actuellement, le nettoyage des masques utilisés dans l'industrie électronique s'effectue en milieu aqueux à l'aide de solutions contenant généralement des sulfates. Ce traitement est effectué hors des installations de fabrication des semiconducteurs et présente plusieurs inconvénients.

Un premier inconvénient est l'acheminement des masques à nettoyer dans une autre installation, généralement celle du fabricant de masques. En effet, on doit respecter le plus possible l'atmosphère contrôlée de la "salle blanche" et toute entrée-sortie de matériel pose problème.

Un autre inconvénient est l'utilisation de solutions à base de sulfates pour le nettoyage. En effet, des résidus (H₂SO₄) gazeux restent présents au retour du masque dans la salle blanche. La présence d'ammoniaque (NH₃) dans la salle blanche (composé largement utilisé dans la fabrication des semiconducteurs) favorise alors la croissance ultérieure de sels de sulfates d'ammonium (NH₄)₂SO₄ à la surface du masque. Cette pollution s'ajoute à celle provenant des autres gaz présents dans l'installation.

De plus, tous les traitements visant à diminuer le dépôt de sels sur des masques (par exemple, le maintien d'un flux d'air contrôlé pendant l'exposition lumineuse) ne font qu'espacer les nettoyages et imposent des contraintes en salle blanche, ce qui accroît le coût global de fabrication des circuits électroniques.

### Résumé de l'invention

La présente invention vise à pallier tout ou partie des inconvénients des procédés de nettoyage de masques utilisés en photolithographie.

L'invention vise plus particulièrement une solution particulièrement adaptée à l'industrie microélectronique.

L'invention vise également une solution susceptible d'être mise en oeuvre en salle blanche, c'est-à-dire dans les installations où sont utilisés les masques.

Pour atteindre tout ou partie de ces objets ainsi que d'autres, la présente invention prévoit un procédé de nettoyage de masques utilisés pour des étapes de photolithographie, comportant au moins une étape de traitement thermique sous pompage à une pression inférieure à la pression atmosphérique et à une température supérieure à la température ambiante.

Selon un mode de mise en oeuvre de la présente invention, la température du traitement thermique est inférieure à 100°C, de préférence, de l'ordre de 80°C.

Selon un mode de mise en oeuvre de la présente invention, le traitement thermique est effectué sous une pression inférieure à 0,01 Pa.

Selon un mode de mise en oeuvre de la présente invention, le traitement thermique est obtenu par rayonnement focalisé sur la surface à nettoyer.

Selon un mode de mise en oeuvre de la présente invention, le procédé comporte une étape de remise à la pression atmosphérique sous gaz neutre en fin de traitement thermique.

Selon un mode de mise en oeuvre de la présente invention, le traitement thermique est poursuivi tant que la concentration d'au moins une espèce de gaz sublimée par le traitement est supérieure à un seuil.

Selon un mode de mise en oeuvre de la présente invention, le traitement thermique est poursuivi tant que des sels sont présents à la surface du masque.

L'invention prévoit également un équipement de nettoyage de masques de photolithographie, comportant:
une chambre de traitement thermique ;
un équipement robotisé de transfert des masques entre la chambre et une boîte externe de stockage ; et
un circuit de pompage des gaz de la chambre de traitement.

Selon un mode de réalisation de la présente invention, l'équipement comporte en outre un circuit d'amenée d'un gaz neutre dans la chambre de traitement.

Selon un mode de mise en oeuvre de la présente invention, l'équipement comporte une unité de commande.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment est destinée à exposer l'état de la technique et le problème posé ;
la figure 2 illustre, de façon très schématique et sous forme de blocs, un mode de mise en oeuvre du procédé de nettoyage de masques selon la présente invention ; et
la figure 3 représente, de façon très schématique, un mode de réalisation d'un équipement de nettoyage selon la présente invention.

Pour des raisons de clarté, seuls les étapes et éléments qui sont utiles à la compréhension de l'invention ont été représentés et seront décrits par la suite. En particulier, l'utilisation faite des masques pour la fabrication de produits électroniques n'a pas été illustrée, l'invention étant compatible avec toute utilisation classique de masques de photolithographie.

### Description détaillée

Une caractéristique d'un mode de mise en oeuvre de la présente invention est de soumettre les masques à nettoyer à un traitement basse pression (inférieure à la pression atmosphérique) de façon à obtenir la vaporisation des sels accumulés en surface du masque, ce traitement thermique étant effectué sous pompage afin d'évacuer les gaz obtenus.

Il n'est pas envisageable de soumettre les masques utilisés dans l'industrie microélectronique à des traitements thermiques de plusieurs centaines de degrés pour obtenir un changement de phase des sels accumulés, car cela entraînerait des déformations des masques. De plus, la pellicule de protection qui est généralement rapportée sur leur partie active fondrait à de telles températures.

La présente invention tire profit du fait que si les températures respectives de sublimation des différents sels accumulés sur un masque (notamment du sulfate d'ammonium) sont de plusieurs centaines de degrés à la pression atmosphérique, cette température de changement de phase vers l'état gazeux diminue avec la pression et atteint, sous des pressions inférieures à 1 Pa, des températures inférieures à une centaine de degrés qui sont compatibles avec la tenue thermique des masques. Toutefois, des vides trop poussés sont également susceptibles d'endommager le masque en provoquant le décollement ou l'arrachement de certaines couches. L'invention tire profit de fait que la plage de température-pression utilisable est compatible avec les tenues thermiques et en dépression des masques et offre une possibilité de réglage pour s'adapter à différents masques, sels et installations.

La figure 2 illustre, de façon très schématique et sous forme de blocs, un mode de mise en oeuvre du procédé de nettoyage de masques selon la présente invention.

La figure 3 représente, de façon très schématique, un mode de réalisation d'un équipement de nettoyage de masques selon le mode de mise en oeuvre de la figure 2.

Dans une installation de l'industrie microélectronique, les différents masques 10 sont transportés dans des boîtes 31 dans lesquelles ils sont maintenus sous atmosphère contrôlée. Un masque 10 à nettoyer (comportant des sels s à sa surface) est introduit (bloc 22, DECONT-CHAMB) dans une chambre de traitement ou de décontamination 32 de l'équipement 3 de nettoyage. Cette étape utilise, par exemple, un robot 33 (TRANSFERT) de transfert du masque à traiter entre la boîte de stockage 31 et la chambre 32, ce robot étant déplacé dans l'équipement 3 entre une porte 321 de la chambre de décontamination et une porte 331 de l'équipement, en vis-à-vis d'une porte correspondante de la boîte 31. Le cas échéant, plusieurs masques sont introduits dans la chambre 32.

La chambre de décontamination 32 est alors soumise à un traitement sous vide 23 (VACUUM) au moyen d'une pompe à vide 34 (PUMP), un système de chauffage 35 étant activé (bloc 24, 80°C) préalablement, en même temps ou postérieurement au démarrage de la mise sous vide. La mise sous vide et la montée en température s'effectuent de préférence progressivement afin de ne pas endommager le masque (notamment la pellicule 14). La température finale est choisie pour être inférieure à la température maximale que peut supporter le masque 10.

De préférence, la température est choisie pour obtenir une sublimation des sels en fonction de la pression acceptable par le masque et accessible par la pompe. Les plages ci-dessous donnent des exemples de températures approximatives sélectionnables en fonction de la pression :
entre 1 et 0,01 Pa, entre 95 et 105°C ;
entre 0,01 et 0,001 Pa, entre 75 et 85°C;
entre 0,001 et 10⁻⁴ Pa, entre 45 et 50°C ; et
entre 10⁻⁵ et 10⁻⁶ Pa, entre 30 et 35°C.

Ces plages peuvent varier en fonction des sels, de l'humidité, du matériau constitutif du masque.

Pour une pression donnée, il n'est pas gênant de choisir une température supérieure à celle requise pour le changement de phase. Au contraire, cela accélère la sublimation des sels, donc le nettoyage.

Un exemple de compromis est une température comprise entre 75 et 100°C, de préférence d'environ 80°C, et une pression comprise entre 10⁻⁴ et 0,001 Pa, de préférence inférieure à 0,001 Pa.

Le traitement sous vide permet, en maintenant le pompage des gaz au moyen de la pompe 34, une évacuation des sels vaporisés dans la chambre de décontamination et ainsi de nettoyer le masque 10.

En fin de traitement thermique sous vide, la chambre de décontamination est (bloc 25, Tamb, N₂) remise à température ambiante Tamb et à pression atmosphérique, de préférence sous gaz neutre (par exemple de l'azote). Le masque traité est enfin évacué de l'équipement 3 vers la boîte 31 au moyen du robot de transfert 33. Le refroidissement peut être naturel ou forcé.

Pour l'évacuation des gaz et l'introduction d'azote, la chambre 32 communique par exemple d'une part avec la pompe 34 d'évacuation vers l'extérieur par une conduite 37 et d'autre part avec une conduite d'amenée de gaz 36. Ces conduites sont équipées de vannes commandables 43 et 44.

Le chauffage pour baisser la pression de changement de phase peut être global dans la chambre ou localisé en utilisant un rayonnement lumineux ou laser. Un avantage d'un chauffage localisé est de focaliser le traitement thermique à la surface sur laquelle se déposent les sels. Cette surface du masque (généralement un quartz) supporte des températures plus élevées que le reste du masque qui comporte entre autres des pièces en plastique. Cela permet d'obtenir une température locale plus élevée moins contraignante en pression, par exemple d'environ 200°C sous 10 Pa, sans endommager le masque.

L'équipement 3 de nettoyage est de préférence commandé par une unité de commande 4 (CTRL), par exemple un automate programmable ou un ordinateur, qui exploite des informations fournies par des capteurs 41 et 42 de température (T) et de pression (P) dans la chambre de décontamination, et commande de façon appropriée la pompe à vide 34, le système de chauffage 35 ainsi que les vannes 43 et 44. L'unité 4 commande également le transfert des masques entre la boîte 31 et la chambre de décontamination.

Le traitement thermique sous vide (blocs 23 et 24) dans la chambre de décontamination est maintenu pendant une durée permettant la disparition des sels de la surface du masque.

Selon un premier mode de mise en oeuvre, cette disparition est vérifiée visuellement par un hublot (non représenté) de la chambre de décontamination 32 permettant de voir la surface du masque.

Selon un autre mode de mise en oeuvre, cette vérification est effectuée en analysant les gaz sortant de la chambre de décontamination 32. Pour cela, la conduite 37 d'évacuation des gaz de la pompe à vide 34 traverse un analyseur 45 (GAZ) dont les résultats sont, de préférence, communiqués à l'unité 4 pour arrêter le traitement thermique sous vide lorsque les concentrations de gaz provenant des sels (SO₄⁻, F, Cl⁻, NH₃, CH₃COO⁻, etc.) sont inférieures à des seuils. En variante, l'analyseur est placé entre la chambre 32 et la pompe 34. Les seuils sont choisis en fonction de la qualité de nettoyage souhaitée.

Selon un autre mode de mise en oeuvre, le temps de traitement est programmé après avoir été validé de façon expérimentale pour des masques de même type.

Un avantage de la présente invention est que le nettoyage réalisé ne réintroduit pas de polluant pour les utilisations ultérieures du masque.

Un autre avantage de l'invention est que l'absence de recours à des solutions aqueuses facilite sa mise en oeuvre dans des salles blanches utilisées pour la fabrication de circuits électroniques.

Un avantage d'un traitement en salle blanche de l'industrie électronique est que l'air y est généralement mieux contrôlé que dans les installations de fabrication des masques, ce qui améliore la propreté des masques. Un autre avantage est que cela évite alors le transfert des masques à nettoyer vers d'autres installations.

Bien entendu, la présente invention est susceptible de diverses variantes et modifications qui apparaîtront à l'homme de l'art. En particulier, bien que l'invention ait été décrite plus particulièrement avec une application à l'industrie électronique, elle s'applique plus généralement à toute industrie dans laquelle sont utilisés des masques de photolithographie susceptibles de se retrouver en présence de gaz formant des sels en surface du masque. De plus, la mise en oeuvre pratique de l'invention à partir des indications fonctionnelles données ci-dessus est à la portée de l'homme du métier, notamment pour ce qui est des durées de traitement et des temps de montée en température, de descente en pression et de remise à l'atmosphère.

## Revendications

1. Procédé de nettoyage de masques (10) utilisés pour des étapes de photolithographie, **caractérisé en ce qu'**il comporte au moins une étape (23, 24) de traitement thermique sous pompage à une pression inférieure à la pression atmosphérique et à une température supérieure à la température ambiante.

2. Procédé selon la revendication 1, dans lequel la température du traitement thermique basse pression est inférieure à 100°C, de préférence, de l'ordre de 80°C.

3. Procédé selon l'une quelconque des revendications 1 et 2, dans lequel le traitement thermique est effectué sous une pression inférieure à 1 Pa, de préférence inférieure à 0,001 Pa.

4. Procédé selon l'une quelconque des revendications 1 à 3, dans lequel le traitement thermique est obtenu par rayonnement focalisé sur la surface à nettoyer.

5. Procédé selon l'une quelconque des revendications 1 à 4, comportant en fin de traitement thermique une étape de remise à la pression atmosphérique sous gaz neutre (N₂).

6. Procédé selon l'une quelconque des revendications 1 à 5, dans lequel le traitement thermique est poursuivi tant que la concentration d'au moins une espèce de gaz sublimée par le traitement est supérieure à un seuil.

7. Procédé selon l'une quelconque des revendications 1 à 6, dans lequel le traitement thermique est poursuivi tant que des sels sont présents à la surface du masque.

8. Equipement de nettoyage de masques de photolithographie, **caractérisé en ce qu'**il comporte :
une chambre (32) de traitement thermique ;
un équipement robotisé (33) de transfert des masques entre la chambre (32) et une boîte (31) externe de stockage ; et
un circuit (34, 37, 43) de pompage des gaz de la chambre de traitement.

9. Equipement selon la revendication 8, comportant en outre un circuit (44, 36), d'amené d'un gaz neutre dans la chambre de traitement (32).

10. Equipement selon l'une quelconque des revendications 8 et 9, comportant une unité (4) de commande pour la mise en oeuvre du procédé selon l'une quelconque des revendications 1 à 7.
